# EUROPÄISCHE PATENTSCHRIFT

(11) **EP 4 022 673 B1**
(45) Veröffentlichungstag und Bekanntmachung des Hinweises auf die Patenterteilung: **13.08.2025**
(21) Anmeldenummer: 20820810.8
(22) Anmeldetag: 03.12.2020
(51) Int. Cl.: H01L 23/373, H01L 21/48

(54) **VERFAHREN ZUR HERSTELLUNG EINES METALL-KERAMIK-SUBSTRATS**
METHOD FOR PRODUCING A METAL-CERAMIC SUBSTRATE
PROCÉDÉ DE FABRICATION D'UN SUBSTRAT MÉTAL-CÉRAMIQUE

(30) Priorität: 19.12.2019 DE 102019135097
(43) Veröffentlichungstag der Anmeldung: 06.07.2022
(73) Patentinhaber: Rogers Germany GmbH, 92676 Eschenbach (DE)
(72) Erfinder: SCHMIDT, Karsten, 92676 Eschenbach (DE); WELKER, Tilo, 91284 Neuhaus (DE); BRITTING, Stefan, 91220 Schnaittach (DE)
(74) Vertreter: Müller Schupfner & Partner Patent- und Rechtsanwaltspartnerschaft mbB (Muc)
(86) Internationale Anmeldenummer: PCT/EP2020/084467
(87) Internationale Veröffentlichungsnummer: WO 2021/122034

(56) Entgegenhaltungen:
- WO-A1-93/23246
- DE-A1- 102014 114 132
- US-A- 4 611 745
- US-A- 5 672 848
- US-A1- 2012 114 966
- US-A1- 2017 271 173
- US-B1- 6 261 703

## Beschreibung

Die vorliegende Erfindung betrifft ein Verfahren zur Herstellung eines Metall-Keramik-Substrats.

Metall-Keramik-Substrate sind beispielsweise als Leiterplatten oder Platinen aus dem Stand der Technik hinlänglich bekannt, beispielsweise aus der DE 10 2013 104 739 A1, der DE 19 927 046 B4 und der DE 10 2009 033 029 A1. Typischerweise werden auf einer Bauteilseite des Metall-Keramik-Substrats Anschlussflächen für elektrische Bauteile und Leiterbahnen angeordnet, wobei die elektrischen Bauteile und die Leiterbahnen zu elektrischen Schaltkreisen zusammenschaltbar sind. Wesentliche Bestandteile der Metall-Keramik-Substrate sind eine Isolationsschicht, die bevorzugt aus einer Keramik gefertigt ist, und wenigstens eine an die Isolationsschicht angebundene Metallschicht. Wegen ihrer vergleichsweise hohen Isolationsfestigkeiten haben sich aus Keramik gefertigte Isolationsschichten in der Leistungselektronik als besonders vorteilhaft erwiesen. Durch eine Strukturierung der Metallschicht können sodann Leiterbahnen und/oder Anschlussflächen für die elektrischen Bauteile realisiert werden.

Voraussetzung für das Bereitstellen eines solchen Metall-Keramik-Substrats ist eine dauerhafte Anbindung der Metallschicht an die Keramikschicht. Neben einem sogenannten Direktanbindungsverfahren, d. h. DCB- oder DAB-Verfahren, ist es aus dem Stand der Technik bekannt, die Metallschicht über ein Lotmaterial an die Keramikschicht anzubinden. Aus der EP 3 041 042 A1 ist beispielsweise eine phosphorhaltige Lotfolie bekannt, mit der eine entsprechende Bindung erzielt werden kann.

Aus der DE 10 2014 114 132 A1 ist ein Verfahren zur Anbindung einer Metallschicht an ein Keramikelement bekannt, bei dem eine Aktivlotschicht zur Bindung verwendet wird. In der US 2017 271 137 A1 wird eine Anbindung einer Metallschicht an ein Keramikelement gelehrt. Die Lehre der US 5 672 848 A beschäftigt sich mit der Verbesserung der Benetzung einer Isolationsschicht. WO 93/23246 offenbart ein Verfahren zur Herstellung eines Metall-Keramik-Substrats, bei dem mindestens eine Keramikschicht und mindestens eine Metallschicht entlang einer Stapelrichtung übereinander angeordnet sind.

Ausgehend von diesem Stand der Technik macht es sich die vorliegende Erfindung zur Aufgabe, ein verbessertes Verfahren zur Anbindung der Metallschicht an die Keramikschicht bereitzustellen, das insbesondere in Hinblick auf die thermomechanischen Belastungen während der Fertigung und Hinblick auf sein Anbindungsspektrum bezüglich der zu verbindenden Keramikschichten verbessert ist. Diese Aufgabe wird durch ein Verfahren zur Herstellung eines Metall-Keramik-Substrats gemäß Anspruch 1 gelöst. Weitere Vorteile und Eigenschaften ergeben sich aus den Unteransprüchen sowie der Beschreibung und den beigefügten Figuren.

Gemäß einem ersten Aspekt der vorliegenden Erfindung ist ein Verfahren zur Herstellung eines Metall-Keramik-Substrats, bei dem mindestens eine Keramikschicht und mindestens eine Metallschicht entlang einer Stapelrichtung übereinander angeordnet sind, vorgesehen, umfassend:
- Bereitstellen der mindestens einen Keramikschicht,
- Ausbilden einer Schnittstellenmetallisierung auf der mindestens einen Keramikschicht, wobei die Schnittstellenmetallisierung eine Aktivmetallschicht und eine Benetzungsmetallschicht umfasst, und
- Anbinden der mindestens einen Metallschicht an die Schnittstellenmetallisierung, insbesondere mittels eines Direktmetallverbindungsverfahrens, wie beispielsweise einem DCB- oder DAB-Verfahren, oder eines Aktivlötverfahrens, zur Ausbildung des Metall-Keramik-Substrats,
wobei die Aktivmetallschicht und/oder die Benetzungsmetallschicht zum Ausbilden der Schnittstellenmetallisierung einem Energieeintrag ausgesetzt wird, wobei als Energieeintrag Licht oder ein induktives Erwärmen verwendet wird.

Gegenüber den aus dem Stand der Technik bekannten Verfahren verwendet das erfindungsgemäße Verfahren eine Schnittstellenmetallisierung, die auf der mindestens einen Keramikschicht, vorzugsweise auf einer Oberseite und/oder Unterseite der mindestens einen Keramikschicht, ausgebildet ist. Eine derartige Schnittstellenmetallisierung erweist sich insbesondere deswegen als vorteilhaft, weil sie die Anbindung einer Metallschicht auch in solchen Fällen gestattet, in denen beispielsweise eine Anbindung über ein DCB- bzw. DAB-Verfahren nach Stand der Technik nicht möglich ist. Dies trifft insbesondere auf nitridische Keramiken, insbesondere Siliziumnitrid und Aluminiumnitrid, zu. Im Falle eines geplanten Lötens, insbesondere Aktivlötens, gestattet die Schnittstellenmetallisierung zudem eine flexiblere Wahl des Lotmaterials, insbesondere insofern, als dass auch solche Lotmaterialien Verwendung finden können, deren Schmelztemperatur für den Lötprozess unterhalb von 800°C, bevorzugt unterhalb von 700°C und besonders bevorzugt unterhalb von 600°C liegen. Dadurch wird der vollzogene Lötprozess bei einer niedrigeren Prozesstemperatur durchgeführt, was sich wiederum positiv auf die andernfalls im Metall-Keramik-Substrat entstehenden thermomechanischen Spannungen auswirkt.

Erfindungsgemäß handelt es sich um derartige Metall-Keramik-Substrate, die durch eine entsprechende Strukturierung als Leiterplatten bzw. "printed circuit boards" (PCB) verwendet werden. Beispielsweise wird das Verfahren zur Ausbildung von Großkarten herangezogen, wobei aus der Großkarte im Anschluss in einem Vereinzelungsprozess mehrere vereinzelte Metall-Keramik-Substrate gebildet werden. Beispielsweise erfolgt eine Strukturierung im Anschluss an die Anbindung der mindestens einen Metallschicht an die Schnittstellenmetallisierung, vorzugsweise mittels eines Ätz- und/oder Fräsvorgangs. Durch die Strukturierung können entsprechende Leiterbahnen und/oder Anschlüsse bereitgestellt werden. Es ist für den Fachmann bevorzugt vorgesehen, dass neben einer mindestens einen Metallschicht an einer Oberseite der mindestens einen Keramikschicht mindestens eine auf der gegenüberliegenden Seite als Rückseitenmetallisierung dienende eine weitere Metallschicht vorgesehen ist. Beispielsweise entspricht die mindestens eine weitere Metallschicht der weiteren Metallschicht, insbesondere in Hinblick auf Form und/oder Dicke und/oder Material.

Insbesondere unterscheiden sich die Aktivmetallschicht und die Benetzungsmetallschicht in Hinblick auf ihre Materialwahl. Beispielsweise handelt es sich bei dem Material für die Aktivmetallschicht um Ti, Zr, Hf, Cr, Nb und/oder V und bei der Benetzungsmetallschicht um Cu, Ag, Ni, In und/oder ähnliche Metalle. Denkbar ist auch, dass als Benetzungsmetallschicht ein Kupferoxid verwendet wird, insbesondere wenn die Aktivmetallschicht in einer Prozessgasatmosphäre unter Aufwendung eines Energieeintrags und/oder weiteren Energieeintrags an die mindestens eine Keramikschicht angebunden wurde. Weiterhin ist es vorgesehen, dass die Benetzungsmetallschicht unmittelbar an die Aktivmetallschicht in Stapelrichtung gesehen angrenzt. Weiterhin ist es vorstellbar, dass die Benetzungsmetallschicht und/oder Aktivmetallschicht an der Oberseite sich unterscheidet von der Benetzungsmetallschicht und/oder Aktivmetallschicht an der Unterseite der mindestens einen Keramikschicht oder einer mindestens einen weiteren Keramikschicht.

Ferner umfasst das Metall-Keramik-Substrat mindestens eine Metallschicht, die an einer Oberseite mindestens einer Keramikschicht stoffschlüssig angebunden ist, wobei sich die mindestens eine Metallschicht und die mindestens eine Keramikschicht entlang einer Haupterstreckungsebene erstrecken und entlang einer senkrecht zur Haupterstreckungsebene verlaufenden Stapelrichtung übereinander angeordnet sind. Als Materialien für die mindestens eine Metallschicht sind Kupfer, Aluminium, Molybdän und/oder deren Legierungen, sowie Laminate wie CuW, CuMo, CuAl, AlCu und/oder CuCu vorstellbar, insbesondere eine Kupfer-Sandwichstruktur mit einer ersten Kupferschicht und einer zweiten Kupferschicht, wobei sich eine Korngröße in der ersten Kupferschicht von einer zweiten Kupferschicht unterscheidet. Weiterhin ist bevorzugt vorgesehen, dass die mindestens eine Metallschicht oberflächenmodifiziert ist. Als Oberflächenmodifikation ist beispielsweise eine Versiegelung mit einem Edelmetall, insbesondere Silber und/oder Gold, oder ENIG ("*electroless nickel immersion gold*") oder ein Kantenverguss an der ersten bzw. zweiten Metallisierungsschicht zur Unterdrückung einer Rissbildung bzw. -weitung denkbar.

Vorzugsweise weist die mindestens eine Keramikschicht Al₂O₃, Si₃N₄, AIN, eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) oder ZTA als Material für die Keramik auf. Es ist dabei auch vorstellbar, dass mindestens eine Keramikschicht als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einer Isolationsschicht zusammengefügt sind. Vorzugsweise wird eine möglichst wärmeleitfähige Keramik für einen möglichst geringen Wärmwiderstand verwendet.

Weiterhin ist es vorstellbar, dass neben der mindestens einen Keramikschicht mindestens eine weitere Keramikschicht vorgesehen, wobei zwischen der mindestens einen Keramikschicht und der mindestens einen weiteren Keramikschicht eine metallische Zwischenschicht angeordnet ist, wobei die metallische Zwischenschicht vorzugsweise dicker als 1,4 mm ist und/oder dicker als die mindestens eine Keramikschicht und die mindestens eine weitere Keramikschicht. Beispielsweise ist hierbei die mindestens eine Metallschicht an der mindestens einen Keramikschicht und eine als Rückseitenmetallisierung vorgesehene Metallschicht an der mindestens einen weiteren Keramikschicht angebunden.

Dabei wird vorzugsweise die mindestens eine Metallschicht an die mindestens eine Keramikschicht mittels eines AMB-Verfahrens und/oder ein DCB-Verfahren stoffschlüssig angebunden.

Unter einem "DCB-Verfahren" (Direct-Copper-Bond-Technology) oder einem "DAB-Verfahren" (Direct-Aluminium-Bond-Technology) versteht der Fachmann ein solches Verfahren, das beispielsweise zum Verbinden von Metallschichten oder - blechen (z. B. Kupferblechen oder -folien oder Aluminiumblechen oder -folien) miteinander und/oder mit Keramik oder Keramikschichten dient, und zwar unter Verwendung von Metall- bzw. Kupferblechen oder Metall- bzw. Kupferfolien, die an ihren Oberflächenseiten eine Schicht oder einen Überzug (Aufschmelzschicht), aufweisen. Bei diesem beispielsweise in der US 3 744 120 A oder in der DE23 19 854 C2 beschriebenen Verfahren bildet diese Schicht oder dieser Überzug (Aufschmelzschicht) ein Eutektikum mit einer Schmelztemperatur unter der Schmelztemperatur des Metalls (z. B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Insbesondere weist das DCB-Verfahren dann z. B. folgende Verfahrensschritte auf:
- Oxidieren einer Kupferfolie derart, dass sich eine gleichmäßige Kupferoxidschicht ergibt;
- Auflegen des Kupferfolie auf die Keramikschicht;
- Erhitzen des Verbundes auf eine Prozesstemperatur zwischen etwa 1025 bis 1083°C, z. B. auf ca. 1071°C;
- Abkühlen auf Raumtemperatur.

Unter einem Aktivlot-Verfahren z. B. zum Verbinden von Metallschichten oder Metallfolien, insbesondere auch von Kupferschichten oder Kupferfolien mit Keramikmaterial ist ein Verfahren zu verstehen, welches speziell auch zum Herstellen von Metall-Keramik-Substraten verwendet wird, wird bei einer Temperatur zwischen ca. 650-1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist. Alternativ ist zur Anbindung auch ein Dickschichtverfahren vorstellbar.

Ferner ist es vorgesehen, dass das Verfahren ein zumindest abschnittweise primäres Anordnen der Aktivmetallschicht auf der mindestens einen Keramikschicht und ein zumindest abschnittsweise sekundäres Anordnen der Benetzungsmetallschicht auf der Aktivmetallschicht umfasst, wobei vorzugsweise zwischen dem primären Anordnen und dem sekundären Anordnen die Aktivmetallschicht einem weiteren Energieeintrag ausgesetzt wird. Dadurch wird bereits ein Aufschmelzen der Aktivmetallschicht vor dem sekundären Anordnen der Benetzungsmetallschicht vorgenommen. Alternativ ist es beispielsweise vorstellbar, dass auf diesen weiteren Energieeintrag verzichtet wird und der Energieeintrag zur Ausbildung der Schnittstellenmetallisierung durchgeführt wird, nachdem das primäre und sekundäre Anordnen abgeschlossen wurde. Dadurch lässt sich auf den weiteren Energieeintrag verzichten, wodurch das Verfahren beschleunigt wird.

Bei der Verwendung eines weiteren Energieeintrags kann ein vergleichsweise kleinerer weitere Energieeintrag nach dem primären Anordnen (und vor dem sekundären Anordnen) bereits zum Aufschmelzen der Aktivmetallschicht verwendet werden, wodurch der Energieaufwand bei der Anbindung der Aktivmetallschicht an die mindestens eine Keramikschicht reduziert werden kann, da der später erfolgende Energieeintrag nach dem primären und sekundären Anordnen nicht durch die Benetzungsmetallschicht hindurchdringen muss. Insbesondere erweist sich die Nutzung des weiteren Energieeintrags, d. h. nach dem primären Anordnen, als vorteilhaft, wenn eine vergleichsweise dicke Benetzungsmetallschicht vorgesehen ist, d. h. bei Benetzungsmetallschichten mit einer zweiten Dicke, die größer als 300 nm ist. Ein reduzierter weiterer Energieeintrag bzw. reduzierter Energieeintrag erweist sich dabei ferner als vorteilhaft, da das Metall-Keramik-Substrat geringeren Belastungen, insbesondere thermischer Belastungen im Rahmen des Fertigungsprozesses ausgesetzt ist.

Vorzugsweise ist es vorgesehen, dass das primäre Anordnen und/oder das sekundäre Anordnen mittels eines Abscheidungsverfahrens, insbesondere mittels eines physikalischen Gasabscheidungsverfahrens realisiert wird. Beispielsweise handelt es sich um ein PVD-Sputtern und/oder reaktives Sputtern. Dadurch lassen sich gezielt vergleichsweise dünne Aktivmetallschichten und/oder Benetzungsmetallschichten realisieren, was sich wiederrum positiv auf den erforderlichen Energieeintrag auswirkt, der benötigt wird, um zumindest die Aktivmetallschicht an die mindestens eine Keramikschicht anzubinden. Ferner ist es bevorzugt vorgesehen, dass beispielsweise im Rahmen eines Abscheidungsvorgangs mittels einer entsprechenden Maskierung eine Strukturierung für die Schnittstellenmetallisierung bzw. zumindest für die Aktivmetallschicht und/oder die Benetzungsmetallschicht vorgenommen wird. Eine derartige Strukturierung in der Schnittstellenmetallisierung, die vorzugsweise der geplanten Strukturierung in der mindestens einen Metallschicht entspricht, verhindert mit Vorteil im Bereich der geplanten Strukturierung eine Anbindung der mindestens einen Metallschicht an die mindestens eine Keramikschicht, wodurch der zur finalen Strukturierung vorgesehene Ätzschritt, das sogenannte "second etching", vereinfacht werden kann, d. h. bei dem Ätzschritt, der die Isolationsgräben zwischen einzelnen Metallabschnitten der mindestens einen Metallschicht realisiert. Ferner ist es vorstellbar, dass die Aktivmetallschicht und/oder Benetzungsmetallschicht galvanisch bzw. elektrochemisch realisiert werden.

Gemäß einer weiteren Ausführungsform der vorliegenden Erfindung ist es vorgesehen, dass zwischen der mindestens einen Metallschicht und der Schnittstellenmetallisierung ein Lotmaterial angeordnet wird, wobei die Aktivmetallschicht und/oder die Benetzungsmetallschicht dem Energieeintrag zeitlich nach dem Anordnen des Lotmaterials zwischen der mindestens einen Metallschicht und der Schnittstellenmetallisierung bzw. der Benetzungsmetallschicht ausgesetzt wird. Dadurch lässt sich vergleichsweise schnell ein Metall-Keramik-Substrat herstellen, da insbesondere zunächst alle einzelnen Schichten übereinander gestapelt werden und erst durch einen finalen Energieeintrag der Fügeprozess simultan ausgelöst wird. Dabei erweist es sich insbesondere als vorteilhaft, als Lotmaterial eine Lötfolie zu verwenden, die zwischen der Benetzungsmetallschicht und der mindestens einen Metallschicht angeordnet ist. Dabei können die Aktivmetallschicht und/oder die Benetzungsmetallschicht als Teil der Lötfolie, d. h. als gemeinsame Lötfolie, ausgebildet sein. Weiterhin ist es bevorzugt vorgesehen, dass das Lotmaterial eine Schichtdicke zwischen 1 µm und 100 µm, bevorzugt zwischen 1,5 und 50 µm und besonders bevorzugt zwischen 2 µm und 20 µm aufweist. Insbesondere ist es vorgesehen, dass mit dem Energieeintrag nicht nur Aktivmetallschicht und Benetzungsmetallschicht, sondern auch das Lotmaterial, vorzugsweise die Lotfolie, aufgeschmolzen wird. Vorzugsweise ist der Energieeintrag derartig dimensioniert, dass das Lötmaterial ebenfalls schmilzt. Insbesondere erfolgt der Energieeintrag unmittelbar, nachdem die Aktivmetallschicht, die Benetzungsmetallschicht, das Lotmaterial und die mindestens eine Metallschicht auf der mindestens eine Keramikschicht entlang der Stapelrichtung gestapelt ist.

Beispielsweise handelt es sich bei dem Lotmaterial, um ein silberbasiertes oder ein kupferbasiertes Lotmaterial. In einem silberbasierten Lotmaterial ist Silber die Hauptkomponente, d. h. der Bestandteil mit dem bezüglich der Gewichtsprozente höchsten Anteil, während in einem kupferbasierten Lotmaterial Kupfer die Hauptkomponente ist. Beispiele für ein silberbasiertes Lotmaterial sind AgCu, insbesondere AgCu28, AgCuln, AgCuSn und AgCuGa. Beispiele für ein kupferbasiertes Basismaterial sind Kupfer CuSn, Culn, CuGa, CuInSn, CuInMb, CuGaSn. Auch ist es vorstellbar als Lötmaterial NiCrMn, Sn, SnSb oder SnCu zu verwenden.

Erfindungsgemäß ist es vorgesehen, dass als Energieeintrag und vorzugsweise als weiterer Energieeintrag Licht verwendet wird. Beispielsweise kann es sich bei dem Licht um ein Laserlicht handeln, das in einer oder mehreren Überfahrten über die Aktivmetallschicht und/oder Benetzungsmetallschicht geführt wird, um so zumindest zeitweise, insbesondere zeitlich punktuell, zu einem Aufschmelzen der Aktivmetallschicht und/oder Benetzungsmetallschicht zu führen. Beispielsweise handelt es sich bei dem Laser um einen gepulsten Laser, wie z. B. einen CO₂-Laser und/oder einen Ultrakurzpulslaser, der Pulse mit einer Pulsdauer von wenigen Pikosekunden oder Nanosekunden erzeugt.

Vorzugsweise ist es vorgesehen, dass ein Lichtblitz verwendet wird, wobei der Energieeintrag des Lichtblitzes auf die Aktivmetallschicht und/oder die Benetzungsmetallschicht vorzugsweise mindestens 5 kW, bevorzugt mindestens 8 kW und besonders bevorzugt zwischen 10 kW und 15 kW beträgt. Insbesondere erfolgt der Energieeintrag im Rahmen eines sogenannten "Flashlight-Annealings", bei dem ein Lichtblitz flächendeckend über 0,6 ms bis 20 ms hinweg die Aktivmetallschicht und/oder Benetzungsmetallschicht beleuchtet. So werden die Aktivmetallschicht und/oder die Benetzungsmetallschicht flächendeckend einem kurzen thermischen Schock, beispielsweise in Form einer kurzfristigen (theoretischen) Erwärmung von 800 °C, ausgesetzt. Dabei werden vorzugsweise solche Lichtblitze verwendet, deren Energiedichte zwischen 0,01 J/cm² und 100 J/cm² , bevorzugt zwischen 0,5 J/cm² und 15 J/cm² liegt und/oder deren Pulsdauer zwischen 0,2 ms und 20 ms betragen. Es hat sich herausgestellt, dass durch die Behandlung mit derartigen Lichtblitzen die Ausbildung einer beschriebenen Schnittstellenmetallisierung im Rahmen eines Präparationsschrittes vor dem eigentlichen Anbinden der mindestens einen Metallschicht und/oder einer mindestens einen weiteren Metallschicht möglich ist. Beispielsweise veranlasst der Energieeintrag durch einen entsprechenden Lichtblitz bei dem Aktivmetall die Reaktion

Si₃N₄ + Ti → TiN + Ti₃Si₅.

Im Stand der Technik ist es hingegen vorgesehen, dass der Energieeintrag und/oder weitere Energieeintrag ein Sintern bzw. Temperieren umfasst, d. h. vorzugsweise wird bzw. werden die Aktivmetallschicht und/oder die Benetzungsmetallschicht, insbesondere unter inerten Bedingungen, erhitzt bzw. erwärmt. Denkbar ist, dass das Erwärmen im Vakuum oder in einer Schutzgasatmosphäre durchgeführt wird. Erfindungsgemäß ist es vorgesehen, dass der Energieeintrag über eine induktive Wirkung veranlasst wird. Ferner ist es denkbar, dass die Aktivmetallschicht und/oder die Benetzungsmetallschicht während des Energieeintrags bzw. des weiteren Energieeintrags unter Druck gesetzt sind, d. h. zusammengepresst sind.

Weiterhin ist es bevorzugt vorgesehen, dass die Aktivmetallschicht eine erste Dicke und die Benetzungsmetallschicht eine zweite Dicke aufweist, wobei die erste Dicke und/oder die zweite Dicke einen Wert zwischen 0 nm und 5.000 nm, bevorzugt zwischen 50 nm und 2500 nm und besonders bevorzugt zwischen 100 nm und 1.000 nm annimmt. Insbesondere ist es vorgesehen, dass die erste Dicke und/oder zweite Dicke, insbesondere die Summe der ersten und zweiten Dicke, kleiner ist als eine dritte Dicke der mindestens einen Metallschicht. Vorzugsweise nimmt ein Verhältnis der Summe der ersten Dicke und der zweiten Dicke einen Wert unterhalb von 0,1, bevorzugt kleiner als 0,05 und besonders bevorzugt kleiner als 0,02 an. Dadurch werden vergleichsweise dünne Aktivmetallschichten und Benetzungsmetallschichten bereitgestellt, die eine Ausgestaltung von den gewünschten Schnittstellenmetallisierungen gestattet.

Dabei ist es insbesondere vorgesehen, dass die erste Dicke im Wesentlichen der zweiten Dicke entspricht. Alternativ ist es vorstellbar, dass ein Verhältnis einer ersten Dicke zur zweiten Dicke einen Wert zwischen 0,1 und 0,6 annimmt, bevorzugt zwischen 0,15 und 0,4 und besonders bevorzugt zwischen 0,25 und 0,35 oder dass ein Verhältnis der zweiten Dicke zu der ersten Dicke einen Wert zwischen 0,1 und 2,0; bevorzugt zwischen 0,2 und 1,5; besonders bevorzugt zwischen 0,3 und 1,0 annimmt. Weiterhin ist es besonders bevorzugt vorgesehen, dass die Aktivmetallschicht, d. h. die erste Dicke, mindestens 100 nm dick ist. Eine entsprechend große erste Dicke stellt sicher, dass ausreichend Aktivmetall an der Grenzschicht zwischen Keramik und Metall bereitgestellt wird, um eine erfolgreiche stoffschlüssige Verbindung zwischen der mindestens einen Metallschicht und der mindestens einen Keramikschicht zu realisieren. Insbesondere im Falle des zeitgleichen Aufschmelzens der Aktivmetallschicht, der Benetzungsmetallschicht und des Lotmaterials, hat es sich als vorteilhaft erwiesen als Energieeintrag ein "Flashlight Annealing", ein Tempern, ein induktives Erwärmen und/oder eine Behandlung mit gepulstem Laserlicht zu verwenden. Mit Vorteil werden verschieden Arten von Energieeinträgen verwendet, die zeitgleich oder zeitversetzt auf die Aktivmetallschicht, die Benetzungsmetallschicht und/oder das Lotmaterial wirken.

Vorzugsweise ist vorgesehen, dass zur Ausbildung der Schnittstellenmetallisierung, d. h. während des Energieeintrags und/oder des weiteren Energieeintrags, ein Prozessgas verwendet wird, d. h. die Aktivmetallschicht und/oder die Benetzungsmetallschicht werden während des Energieeintrags und/oder des weiteren Energieeintrags einem Prozessgas ausgesetzt. Beispiele für ein entsprechendes Prozessgas sind Argon, Sauerstoff und/oder Stickstoff. Die Verwendung eines Prozessgases, insbesondere von Stickstoff oder Sauerstoff, kann die Metallschicht, insbesondere die Aktivmetallschicht und die Benetzungsmetallschicht zusätzliche Oxide bzw. Nitride bilden, die bei Lagerung an der Atmosphäre stabil sind. Besonders bevorzugt ist die Verwendung eines induktiven Wärmeeintrags, wenn der Energieeintrag erfolgt nachdem das Lotmaterial und/oder die weitere Metallschicht bzw. die mindestens eine Metallschicht auf der Benetzungsmetallschicht angeordnet ist.

Weiterhin ist es denkbar, dass die mindestens eine Metallschicht und/oder mindestens weitere Metallschicht durchgehend ausgebildet ist, d. h. in Form eines Blechs bzw. in einer Folie.

Ein weiterer Gegenstand ist ein Verfahren zur Herstellung eines Trägersubstrats, umfassend
- Bereitstellen mindestens einer Isolationsschicht;
- Ausbilden einer Schnittstellenmetallisierung auf der mindestens einen Isolationsschicht, wobei die Schnittstellenmetallisierung eine Aktivmetallschicht und eine Benetzungsmetallschicht umfasst, und
- Anbinden der mindestens einen Metallschicht an die Schnittstellenmetallisierung, insbesondere mittels eines Direktmetallverbindungsverfahrens, wie beispielsweise einem DCB oder DAB-Verfahren, oder eines Aktivlötverfahrens, zur Ausbildung des Trägersubstrats,
wobei die Aktivmetallschicht und/oder die Benetzungsmetallschicht zum Ausbilden der Schnittstellenmetallisierung einem Energieeintrag ausgesetzt wird. Beispielsweise ist das Trägersubstrats aus Glas und/oder Kunststoff, insbesondere einem hochtemperaturbeständigen Kunststoff gefertigt. Als besonders vorteilhaft hat sich hierbei das Stapeln von Aktivmetallschicht, Benetzungsmetallschicht und Lotmaterial zur Ausbildung des Trägersubstrats herausgestellt.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsformen können dabei im Rahmen der Erfindung miteinander kombiniert werden.

Es zeigt:
- **Fig.1:**: schematisch ein Metall-Keramik-Substrats gemäß einer ersten bevorzugten Ausführungsform der vorliegenden Erfindung,
- **Fig.2:**: schematisch ein Verfahren zur Herstellung eines Metall-Keramik-Substrats gemäß einer zweiten bevorzugten Ausführungsform der vorliegenden Erfindung,
- **Fig.3:**: schematisch ein Verfahren zur Herstellung eines Metall-Keramik-Substrats gemäß einer dritten bevorzugten Ausführungsform der vorliegenden Erfindung und
- **Fig.4:**: schematisch ein Verfahren zur Herstellung eines Metall-Keramik-Substrats gemäß einer vierten bevorzugten Ausführungsform der vorliegenden Erfindung.

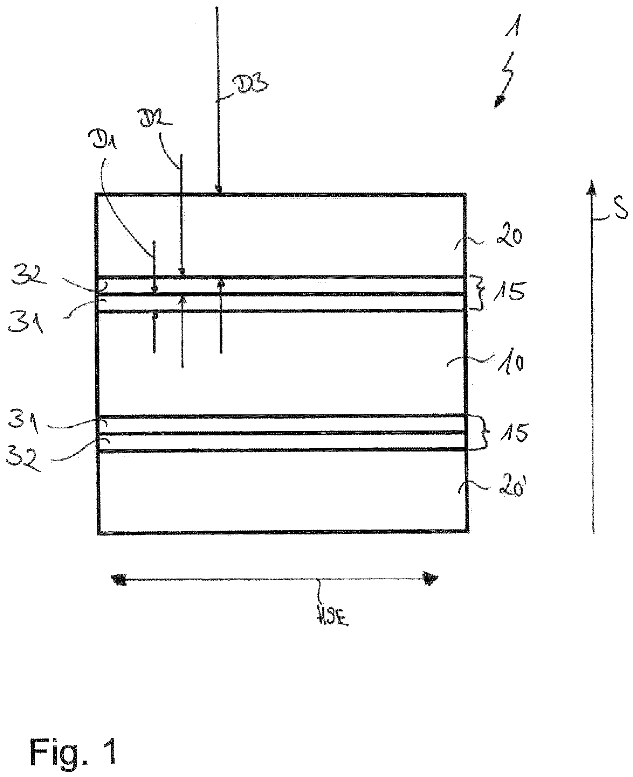

In **Figur 1** ist schematisch ein Metall-Keramik-Substrats 1 gemäß einer ersten bevorzugten Ausführungsform der vorliegenden Erfindung dargestellt. Solch ein Metall-Keramik-Substrat 1 dient vorzugsweise jeweils als Träger von elektronischen bzw. elektrischen Bauteile, die an das Metall-Keramik-Substrat 1 anbindbar sind, d. h. als Leiterplatte bzw. PCB (printed circuit board). Wesentliche Bestandteile eines solchen Metall-Keramik-Substrats 1 sind eine sich entlang einer Haupterstreckungsebene HSE erstreckende mindestens eine Keramikschicht 10 und eine an der mindestens einen Keramikschicht 10 angebundene mindestens eine Metallschicht 20. Die mindestens eine Keramikschicht 10 ist aus mindestens einem eine Keramik umfassenden Material gefertigt. Die mindestens eine Metallschicht 20 und die mindestens eine Keramikschicht 10 sind dabei entlang einer senkrecht zur Haupterstreckungsebene HSE verlaufenden Stapelrichtung S übereinander angeordnet und in einem gefertigten Zustand über eine Anbindungsfläche zumindest bereichsweise miteinander stoffschlüssig verbunden. Erfindungsgemäß wird die mindestens eine Metallschicht 20 dann zur Bildung von Leiterbahnen oder Anbindungsstellen für die elektrischen Bauteile strukturiert. Beispielsweise wird diese Strukturierung in die mindestens eine Metallschicht 20 eingeätzt. Im Vorfeld muss allerdings eine dauerhafte Bindung, insbesondere stoffschlüssige Anbindung, zwischen der mindestens einen Metallschicht 20 und der mindestens einen Keramikschicht 10 gebildet werden.

Um die mindestens eine Metallschicht 20 dauerhaft an die mindestens eine Keramikschicht 10 anzubinden, umfasst eine Anlage zur Herstellung des Metall-Keramik-Substrats 1, beispielswiese in einem DCB oder DAB - Anbindungsverfahren oder Aktivlötverfahren (AMB-Verfahren), einen Ofen, in dem ein gestapelte Anordnung aus der mindestens einen Keramikschicht 10 und der mindestens einer Metallschicht 20 erhitzt wird und so die Bindung erzielt wird. Beispielsweise handelt es sich bei der mindestens einen Metallschicht 20 um eine aus Kupfer gefertigte mindestens eine Metallschicht 20, wobei die mindestens eine Metallschicht 20 und die mindestens eine Keramikschicht 10 mit einem DCB (Direct-Copper-Bonding) - Anbindungsverfahren miteinander verbunden werden. Alternativ lässt sich die mindestens eine Metallschicht über ein Aktivlötverfahren bzw. ein Dickschichtfilmverfahren an die mindestens eine Keramikschicht anbinden.

In dem in Figur 1 dargestellten Ausführungsbeispiel des Metall-Keramik-Substrats 1 ist neben der mindestens einen Metallschicht 20 an der mindestens einen Keramikschicht 10 auf einer gegenüberliegenden Seite mindestens eine weitere Metallschicht 20' vorgesehen. Insbesondere dient die mindestens eine weitere Metallschicht 20' als Rückseitenmetallisierung des Metall-Keramik-Substrats 1.

Insbesondere ist es vorgesehen, dass die mindestens eine Metallschicht 20 und die mindestens eine weitere Metallschicht 20' jeweils über eine Schnittstellenmetallisierung 15 an eine Oberseite und/oder Unterseite der mindestens einen Keramikschicht 10 angebunden sind. Die Nutzung einer Schnittstellenmetallisierung 15 hat den Vorteil, dass beispielsweise im Rahmen eines Lötprozesses auch solche Lotmaterialien Verwendung finden können, deren Löttemperatur niedriger sind als die, die für Lotmaterialien vorgesehen sind, die typischerweise eine Metallschicht 20 direkt an eine Keramikschicht 10 binden können. Dadurch lassen sich die thermischen Belastungen während des Anbindungsprozesses reduzieren. Mit anderen Worten: Die Schnittstellenmetallisierung 15 dient als Adapter zur Anbindung der mindestens einen Metallschicht 20 und/oder der mindestens einen weiteren Metallschicht 20', insbesondere ohne die speziellen Eigenschaften der mindestens einen Keramikschicht 10 berücksichtigen zu müssen. Dies erweist sich insbesondere auch als vorteilhaft, wenn die mindestens eine Metallschicht 20 und/oder die mindestens eine weitere Metallschicht 20' mit mindestens einer Keramikschicht 10 verbunden werden soll, die typischerweise ungeeignet ist für die Anwendung eines DCB bzw. DAB Prozesses bzw. Verfahrens. Beispielsweise lässt sich eine derartige Schnittstellenmetallisierung 15 an einer nitridischen Keramik, insbesondere eine Siliziumnitrid-Keramikschicht anbinden, wodurch über die angebundene Schnittstellenmetallisierung 15 wiederum die Anbindung der mindestens einen Metallschicht 20 oder der mindestens einen weiteren Metallschicht 20' über ein Direktmetallverbindungsverfahren, beispielsweise ein DCB- oder DAB- Verfahren, möglich ist. Dabei umfassen die Schnittstellenmetallisierungen 15 insbesondere an einer Oberseite und/oder Unterseite der mindestens einen Keramikschicht 10 jeweils eine Aktivmetallschicht 31 und eine Benetzungsmetallschicht 32 auf. Dabei schließt insbesondere die Aktivmetallschicht 31 unmittelbar an eine Oberseite und/oder Unterseite der mindestens einen Keramikschicht 10 an, während die Benetzungsmetallschicht 32 an der auf der mindestens einen Keramikschicht 10 angeordneten Aktivmetallschicht 31 angeordnet ist bzw. unmittelbar an die Aktivmetallschicht 31 angrenzt. Beispielsweise ist die Schnittstellenmetallisierung 15 aus einem zweilagigen Schichtsystem mit der Aktivmetallschicht 31 und der Benetzungsmetallschicht 32 geformt. Dabei ist es vorstellbar, dass sich die Aktivmetallschicht 31 und die Benetzungsmetallschicht 32 in der Schnittstellenmetallisierung 15 an der Oberseite von denjenigen Aktivmetallschicht 31 und Benetzungsmetallschicht 32 unterscheidet, die für die Schnittstellenmetallisierung 15 an der Unterseite der mindestens einen Keramikschicht 15 vorgesehen ist.

Weiterhin ist es vorgesehen, dass sich die Schnittstellenmetallisierungen 15 mindestens über 40%, bevorzugt 60% und besonders bevorzugt mehr als 80% einer Oberfläche an der Oberseite und/oder Rückseite der mindestens einen Keramikschicht 10 erstreckt.

Weiterhin ist es bevorzugt vorgesehen, dass der Aktivmetallschicht 31 eine erste Dicke D1, eine Benetzungsmetallschicht 32 eine zweite Dicke D2 und der mindestens einen Metallschicht 20 bzw. der mindestens einen weiteren Metallschicht 20' eine dritte Dicke D3 zugeordnet ist. Dabei nimmt die erste Dicke D1 und/oder die zweite Dicke D1 einen Wert zwischen 0 nm und 5000 nm, bevorzugt zwischen 50 nm und 2.500 nm und besonders bevorzugt zwischen 100 nm und 1000 nm an. Weiterhin ist besonders bevorzugt vorgesehen, dass ein Verhältnis der Summe der ersten Dicke D1 und zweiten Dicke D2 zu der dritten Dicke D3 einen Wert an nimmt, der kleiner ist als 0,1, bevorzugt kleiner als 0,05 und besonders bevorzugt kleiner als 0,02. Mit anderen Worten: Die Schnittstellenmetallisierungsschicht 15 ist vergleichsweise dünn gegenüber der dritten Dicke D3 der mindestens einen Metallschicht 20. Dadurch lassen sich beispielsweise auch dritte Dicken D3 realisieren, die größer als 1 mm, bevorzugt größer als 1,5 mm und besonders bevorzugt zwischen 1,5 mm und 3 mm groß sind. Derartig große dritte Dicken D3 unterstützen mit Vorteil die Wärmespreizung unmittelbar an dem elektrischen Bauteil, das beispielsweise an der mindestens einen Metallschicht 20 angebunden ist.

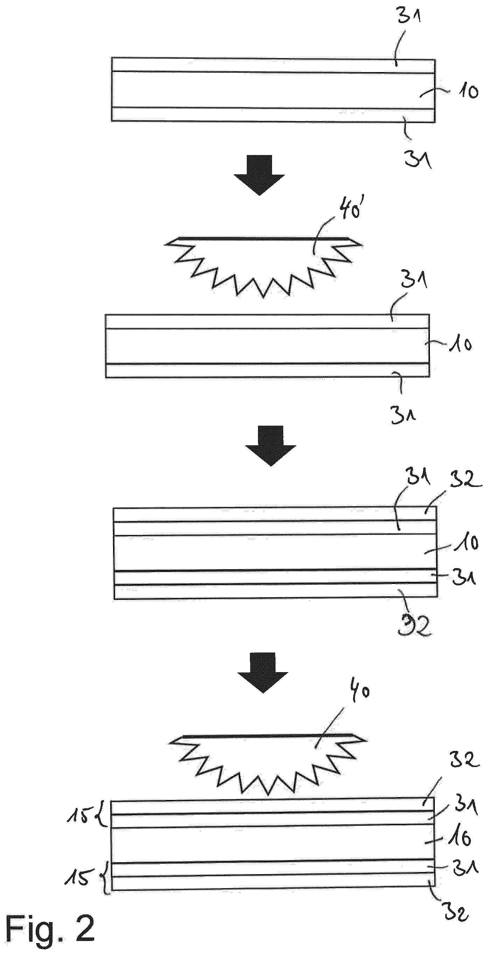

In **Figur 2** ist ein Verfahren zur Herstellung eines Metall-Keramik-Substrats 1 gemäß einer beispielhaften Ausführungsform der vorliegenden Erfindung dargestellt. Insbesondere zeigt die Figur 2 die Präparation der mindestens einen Keramikschicht 10, die zur Ausbildung der Schnittstellenmetallisierung 15 führt. Insbesondere ist es vorgesehen, dass nach einem Bereitstellen der mindestens einen Keramikschicht 10 an einer Oberseite und/oder Rückseite bzw. Unterseite der mindestens einen Keramikschicht 10, vorzugsweise durch einen Abscheidevorgang, wie zum Beispiel durch ein physikalisches Gasphasenabscheiden, flächig ein primäres Anordnen der Aktivmetallschicht 31 auf der mindestens einen Keramikschicht 10 erfolgt. Insbesondere bedeckt die Aktivmetallschicht 31 die mindestens eine Keramikschicht 10 zu mehr als 40%, bevorzugt mehr als 60% und besonders bevorzugt zu mehr als 80%. Ferner sieht das Verfahren vor, dass auf die im Rahmen des primären Anordnens aufgebrachte Aktivmetallschicht 31 wiederum zumindest abschnittsweise eine Benetzungsmetallschicht 32 aufgetragen wird. Dabei kann die Benetzungsmetallschicht 32 die Aktivmetallschicht 31 vollflächig bedecken und/oder nur bis zu 90% bevorzugt bis zu 80 % und besonders bevorzugt bis zu 75 %. Dabei kann sich beispielsweise die Benetzungsmetallschicht 32 an der Oberseite der mindestens einen Keramikschicht 10 von derjenigen an der Unterseite der mindestens einen Keramikschicht 10 unterscheiden, insbesondere hinsichtlich des Materials. Vorzugsweise bedeckt die Benetzungsmetallschicht 32 mindestens 40%, bevorzugt mindestens 60% und besonders bevorzugt mehr als 80% der Aktivmetallschicht 31, die im Rahmen der primären Anordnung bzw. des primären Anordnens auf die mindestens eine Keramikschicht 10 aufgetragen worden ist. Zur Ausbildung einer stoffschlüssigen Verbindung mit der die Schnittstellenmetallisierung 15 an die mindestens eine Keramikschicht 10 angebunden ist, ist es vorgesehen, dass auf die Aktivmetallschicht 31 und/oder die Benetzungsmetallschicht 32 ein Energieeintrag 40 einwirkt.

Mit anderen Worten: Die Aktivmetallschicht 31 und die Benetzungsmetallschicht 32 werden einem Energieeintrag 40 ausgesetzt, sodass die Benetzungsmetallschicht 32 und/oder die Aktivmetallschicht 31 durch den Energieeintrag 40 aufschmelzen, wodurch während des Aufschmelzens das Aktivmetall der Aktivmetallschicht 31 mit der Keramik der mindestens einen Keramikschicht 10 unter Ausbildung einer stoffschlüssigen Verbindung reagiert. Durch die Ausbildung zweier Metallschichten, d. h. der Aktivmetallschicht 31 und der Benetzungsmetallschicht 32 aus unterschiedlichen Metallmaterialien liegt die Schmelztemperatur dabei unterhalb der Schmelztemperatur der jeweiligen Ausgangsmetalle, sodass die thermische Belastung während des Energieeintrags zur Ausbildung der Schnittstellenmetallisierung 15 reduziert ist, insbesondere auch unterstützt wird durch die vergleichsweise geringe erste Dicke D1 bzw. zweite Dicke D2. In dem in Figur 2 dargestellten Ausführungsbeispiel erfolgt neben dem Energieeintrag 40 nachdem die Aktivmetallschicht 31 und die Benetzungsmetallschicht 32 übereinander angeordnet sind zusätzlich ein weiterer Energieeintrag 40', der ausschließlich bzw. lediglich auf die Aktivmetallschicht 31 gerichtet ist. Hierzu wird nach dem primären Anordnen der Aktivmetallschicht 31, und vor dem sekundären Anordnen der Benetzungsmetallschicht 32 ein weiterer Energieeintrag 40' vorgenommen, der zu einer Voranbindung der Aktivmetallschicht 31 an die mindestens eine Keramikschicht 10 führt.

Erfindungsgemäß handelt es sich bei dem Energieeintrag 40 und/oder dem weiteren Energieeintrag 40' um einen Energieeintrag mittels Lichts. Neben der Verwendung von Laserlicht ist es besonders bevorzugt vorgesehen, dass ein Lichtblitz verwendet wird. Insbesondere erfolgt das Ausbilden der Schnittstellenmetallisierung 15 unter Verwendung eines sogenannten "Flashlight Annealing"-Verfahrens, bei dem ein Lichtblitz großflächig die auf der mindestens einen Keramikschicht 10 angeordnete Aktivmetallschicht 31 und/oder Benetzungsmetallschicht 32 für einen vergleichsweise kurzen Zeitraum, d. h. einen Zeitraum zwischen 1 ms und 50 ms, flächig, d. h. über mehr als 50%, besonders bevorzugt mehr als 80% der Oberfläche der aufgetragenen Aktivmetallschicht 31 und/oder Benetzungsmetallschicht 32, beleuchtet. Vorzugsweise entspricht die Leistung des verwendeten Lichts einen Wert von mindestens 5 kW, bevorzugt mindestens 8 kW und besonders bevorzugt einen Wert zwischen 10 kW und 15 kW. Dabei können die einzelnen Lichtpulse Energiedichten zwischen 0,01 J/cm und 100 J/cm aufweisen. Es ist vorstellbar, dass der weitere Energieeintrag 40' durch ein Temperieren, insbesondere im Vakuum, erfolgt. Weiterhin ist es besonders bevorzugt vorgesehen, wenn die Aktivmetallschicht 31 und/oder Benetzungsmetallschicht 32 dem Energieeintrag 40 und/oder dem weiteren Energieeintrag 40' ausgesetzt wird, wenn dies unter einer Prozessatmosphäre bzw. unter Zusetzung eines Prozessgases erfolgt. Beispiele für Prozessgase sind Argon, Sauerstoff und/oder Stickstoff.

Das primäre Anordnen und/oder das sekundäre Anordnen erfolgt beispielsweise mittels eines Sputterns, beispielsweise einem PVD Sputtern und/oder reaktiven Sputtern.

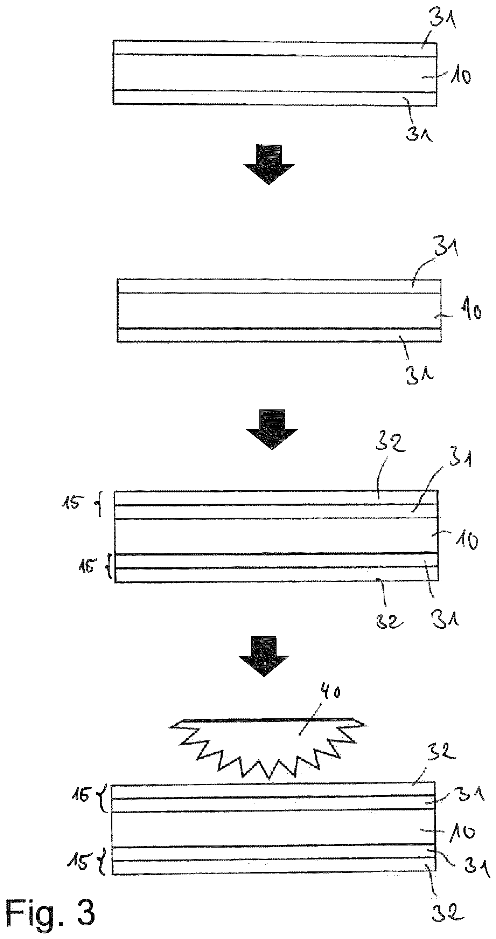

In Figur 3 ist ein Verfahren zur Herstellung eines Metall-Keramik-Substrats 1 gemäß einer zweiten beispielhaften Ausführungsform der vorliegenden Erfindung dargestellt. Das Ausführungsbeispiel aus der Figur 3 unterscheidet sich von denjenigen aus Figur 1 dahingehend, dass im Ausführungsbeispiel der Figur 3 auf einen weiteren Energieeintrag 40' verzichten wird. Entsprechend wird hier zunächst ein primäres und sekundäres Anordnen vorgenommen und erst nach Abschluss des primären und des sekundären Anordnens der Aktivmetallschicht 31 und der Benetzungsmetallschicht 32 wird das Assemble aus der mindestens einen Keramikschicht 10, der Aktivmetallschicht 31 und der Benetzungsmetallschicht 32 dem Energieeintrag 40 ausgesetzt. In den Figuren 2 und 3 sind die Energieeinträge 40 so dargestellt, dass sie auf die Oberseite des Assembles aus mindestens einer Keramikschicht 10, Benetzungsmetallschicht 32 und Aktivmetallschicht 31 gerichtet ist. Für den Fachmann versteht es sich, dass insbesondere zur Anbindung der weiteren Metallisierung 20' und der Ausbildung der hierfür vorgesehenen Schnittstellenmetallisierung 15 an der Unterseite der mindestens einen Keramikschicht 10 der Energieeintrag 40 sowohl an der Oberseite als auch an der Unterseite des Assembles erfolgen können. Denkbar ist es dabei, dass an Oberseite und Unterseite derselbe Energieeintrag oder verschiedene Energieeinträge aufgewendet werden.

Weiterhin ist es vorstellbar, dass das primäre Anordnen und/oder sekundäre Anordnen derart erfolgt, dass die Aktivmetallschicht 31 und/oder die Benetzungsmetallschicht 32 an der Oberseite bzw. der Unterseite der mindestens einen Keramikschicht 10 eine Strukturierung aufweist. Vorzugsweise entspricht die in die Aktivmetallschicht 31 und/oder Benetzungsmetallschicht 32 eingelassene Strukturierung derjenigen, die im gefertigten Metall-Keramik-Substrat 1 für die mindestens eine Metallschicht 20 und/oder die mindestens eine weitere Metallschicht 20' vorgesehen ist. Dabei versteht der Fachmann insbesondere unter einer Strukturierung eine Ausnehmung, die bevorzugt bis zur Oberseite und/oder Unterseite der mindestens einen Keramikschicht 10 reicht. Beispielsweise erfolgt eine Maßnahme für eine derartige Strukturierung vor dem Abscheideverfahren des primären Anordnens und/oder des sekundären Anordnens, indem eine Maskierung vorgenommen wird, die insbesondere der vorgesehenen Strukturierung entspricht. Dadurch wird verhindert, dass in den Bereichen der geplanten Strukturierung Aktivmetall und/oder Benetzungsmetall angeordnet wird. Eine derartige Strukturierung der Aktivmetallschicht 31 und/oder der Benetzungsmetallschicht 32, insbesondere der Schnittstellenmetallisierung 15, erweist sich insbesondere deswegen als vorteilhaft, weil dadurch im finalen Ätzprozess, dem sogenannten "second etching", die stoffschlüssige Verbindung im Grenzbereich zwischen der mindestens einen Keramikschicht 10 und der mindestens einen Metallisierungsschicht 20 nicht weggeätzt werden muss, die sich typischerweise als besonders herausfordernd im Fertigungsprozess herausstellt.

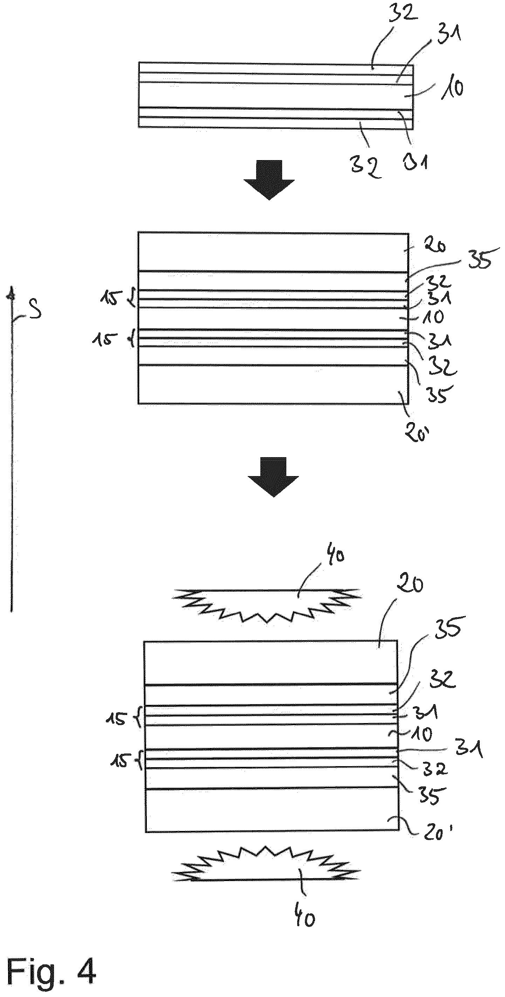

In **Figur 4** ist ein Verfahren zur Herstellung eines Metall-Keramik-Substrats 1 gemäß einer dritten bevorzugten Ausführungsform der vorliegenden Erfindung dargestellt. In dem in Figur 4 dargestellten Ausführungsbeispiel wird der Energieeintrag 40 erst dann vorgenommen, wenn die Metallschicht 20 und/oder die weitere Metallschicht bereits Teil eines Assembles sind, das im Vorfeld bzw. zur Vorbereitung zusammengesetzt ist. Hierzu wird nach dem primären Anordnen der Aktivmetallschicht 31 und dem sekundären Anordnen der Benetzungsmetallschicht 32 ein Lötmaterial 35, vorzugsweise als Lötfolie, auf der Benetzungsmetallschicht 32 angeordnet. Auf das Lötmaterial 35 wird wiederrum die mindestens eine Metallschicht 20 und/oder die mindestens eine weitere Metallschicht 20' angeordnet.

Dieses Assemble, das mindestens eine Keramikschicht 10, die Aktivmetallschicht 31, die Benetzungsmetallschicht 32, das Lötmaterial 35 und die mindestens eine Metallschicht 20 bzw. die mindestens eine weitere Metallschicht 20' umfasst, wird abschließend derart einem Energieeintrag 40 ausgesetzt, dass zeitgleich die Schnittstellenmetallisierung 15 an der Oberseite und/oder Unterseite der mindestens einen Keramikschicht 10 ausgebildet wird und gleichzeitig das Lötmaterial 35 schmilzt, um möglichst simultan die Anbindung der mindestens einen Metallisierungsschicht 20 und/oder der mindestens einen weiteren Metallschicht 20' zu erzielen. Durch das zeitgleiche Ausbilden der Schnittstellenmetallisierung 15 und dem Anbinden der Metallschicht 20 bzw. der mindestens einen weiteren Metallschicht 20' lässt sich ein vergleichsweise schnelles Fertigungsverfahren zur Herstellung von Metall-Keramik-Substraten 1 bereitstellen, bei dem insbesondere solche Lotmaterialien 35 Verwendung finden können, die eine vergleichsweise niedrige Löttemperatur aufweisen. Dadurch wird die Wärmebelastung auf das zu fertigende Metall-Keramik-Substrat 1 möglichst klein gehalten, wodurch wiederrum thermomechanische Belastungen bzw. Spannungen möglichst gering gehalten werden können, die andernfalls zu Spannungen im gefertigten Metall-Keramik-Substrat führen, die schließlich die Lebensdauer des gefertigten Metall-Keramik-Substrats 1 beeinträchtigen könnten. Außerdem ist der Energieaufwand reduziert im Vergleich zu einem Lötprozess, der eine höhere Temperatur benötigt. Vorzugsweise erfolgt dabei der Energieeintrag über einen Lichtblitz, einen Laserpuls, eine induktive Wirkung und/oder Erwärmen.

### Bezugszeichenliste:

- 1: Metall-Keramik-Substrat
- 10: Keramikschicht
- 15: Schnittstellenmetallisierung
- 20: Metallschicht
- 20': weitere Metallschicht
- 31: Aktivmetallschicht
- 32: Benetzungsmetallschicht
- 35: Lotmaterial
- 40: Energieeintrag
- 40': weiterer Energieeintrag
- HSE: Haupterstreckungsebene
- S: Stapelrichtung
- D1: erste Dicke
- D2: zweite Dicke
- D3: dritte Dicke

## Patentansprüche

1. Verfahren zur Herstellung eines Metall-Keramik-Substrats (1), bei dem mindestens eine Keramikschicht (10) und mindestens eine Metallschicht (20) entlang einer Stapelrichtung (S) übereinander angeordnet sind und die mindestens eine Metallschicht (20) zur Bildung von Leiterbahnen oder Anbindungsstellen für elektrische Bauteile strukturiert wird, umfassend
- Bereitstellen der mindestens einen Keramikschicht (10);
- Ausbilden einer Schnittstellenmetallisierung (15) auf der mindestens einen Keramikschicht (10), wobei die Schnittstellenmetallisierung (15) eine Aktivmetallschicht (31) und eine Benetzungsmetallschicht (32) umfasst, und
- Anbinden der mindestens einen Metallschicht (20) an die Schnittstellenmetallisierung (15), insbesondere mittels eines Direktmetallverbindungsverfahrens, wie beispielsweise einem DCB oder DAB-Verfahren, oder eines Aktivlötverfahrens, zur Ausbildung des Metall-Keramik-Substrats (1),
wobei die Aktivmetallschicht (31) und/oder die Benetzungsmetallschicht (32) zum Ausbilden der Schnittstellenmetallisierung (15) einem Energieeintrag (40) ausgesetzt wird **dadurch gekennzeichnet, dass** als Energieeintrag (40) Licht oder ein induktives Erwärmen verwendet wird.

2. Verfahren gemäß Anspruch 1, ferner umfassend
- zumindest abschnittsweises primäres Anordnen der Aktivmetallschicht (31) auf der mindestens einen Keramikschicht (10) und insbesondere
- zumindest abschnittsweises sekundäres Anordnen der Benetzungsmetallschicht (32) auf der Aktivmetallschicht (31), wobei vorzugsweise zwischen dem primären Anordnen und dem sekundären Anordnen die Aktivmetallschicht (31) einem weiteren Energieeintrag (40') ausgesetzt wird.

3. Verfahren gemäß Anspruch 2, wobei das primäre Anordnen und/oder das sekundäre Anordnen mittels eines Abscheidungsverfahrens, insbesondere einem physikalischen Gasphasenabscheidungsverfahrens, realisiert wird.

4. Verfahren gemäß einem der vorhergehenden Ansprüche, wobei zwischen der mindestens einen Metallschicht (20) und der Schnittstellenmetallisierung (15) ein Lotmaterial (35) angeordnet wird, wobei die Aktivmetallschicht (31) und/oder die Benetzungsmetallschicht (32) dem Energieeintrag (40) zeitlich nach dem Anordnen des Lotmaterials (35) zwischen der mindestens einen Metallschicht (20) und der Schnittstellenmetallisierung (15) ausgesetzt wird.

5. Verfahren gemäß einem der vorhergehenden Ansprüche, wobei als weiterer Energieeintrag (40') Licht verwendet wird.

6. Verfahren gemäß Anspruch 5, wobei ein Lichtblitz verwendet wird, wobei der Energieeintrag (40') des Lichtblitzes auf die Aktivmetallschicht (31) und/oder die Benetzungsmetallschicht (32) vorzugsweise mindestens 5 kW, bevorzugt mindestens 8 kW und besonders bevorzugt zwischen 10 und 15 kW beträgt.

7. Verfahren gemäß einem der vorhergehenden Ansprüche, wobei als weiterer Energieeintrag (40') ein Sintern verwendet wird.

8. Verfahren gemäß einem der vorhergehenden Ansprüche, wobei die Aktivmetallschicht (31) eine erste Dicke (D1) und die Benetzungsmetallschicht (32) eine zweite Dicke (D2) aufweist, wobei die erste Dicke (D1) und/oder die zweite Dicke (D2) einen Wert zwischen 0 und 5000 nm, bevorzugt zwischen 50 und 2500 nm und besonders bevorzugt zwischen 100 nm und 1000 nm annimmt.

9. Verfahren zur Herstellung eines Metall-Keramik-Substrats gemäß einem der vorhergehenden Ansprüche , umfassend
- Ausbilden einer Schnittstellenmetallisierung (15) auf der mindestens einen Isolationsschicht , wobei die Schnittstellenmetallisierung (15) eine Aktivmetallschicht (31) und eine Benetzungsmetallschicht (32) umfasst,
wobei die Aktivmetallschicht (31) und/oder die Benetzungsmetallschicht (32) zum Ausbilden der Schnittstellenmetallisierung (15) einem Energieeintrag (40) ausgesetzt wird.

## Claims

1. Method for producing a metal-ceramic substrate (1), in which at least one ceramic layer (10) and at least one metal layer (20) are arranged on top of one another along a stacking direction (S) and the at least one metal layer (20) is structured to form conductor paths or connection points for electrical components, comprising
- providing the at least one ceramic layer (10);
- forming an interface metallization (15) on the at least one ceramic layer (10), wherein the interface metallization (15) comprises an active metal layer (31) and a wetting metal layer (32), and
- bonding the at least one metal layer (20) to the interface metallization (15), in particular by means of a direct metal bonding method, such as a DCB or DAB method, or an active soldering process, in order to form the metal-ceramic substrate (1),
wherein the active metal layer (31) and/or the wetting metal layer (32) is subjected to an energy input (40) in order to form the interface metallization (15) **characterized in that** light or inductive heating is used as the energy input (40).

2. Method according to claim 1, further comprising
- at least partially primary arrangement of the active metal layer (31) on the at least one ceramic layer (10) and in particular
- at least partially secondary arrangement of the wetting metal layer (32) on the active metal layer (31), wherein preferably between the primary arrangement and the secondary arrangement the active metal layer (31) is subjected to a further energy input (40').

3. Method according to claim 2, wherein the primary arrangement and/or the secondary arrangement is carried out by means of a deposition method, in particular a physical vapor deposition method.

4. Method according to one of the preceding claims, wherein a solder material (35) is arranged between the at least one metal layer (20) and the interface metallization (15), wherein the active metal layer (31) and/or the wetting metal layer (32) is exposed to the energy input (40) temporally after the solder material (35) is arranged between the at least one metal layer (20) and the interface metallization (15).

5. Method according to one of the preceding claims, wherein light is used as a further energy input (40').

6. Method according to claim 5, wherein a flash of light is used, wherein the energy input (40') of the flash of light to the active metal layer (31) and/or the wetting metal layer (32) is preferably at least 5 kW, more preferably at least 8 kW and most preferably between 10 and 15 kW.

7. Method according to one of the preceding claims, wherein sintering is used as a further energy input (40').

8. Method according to one of the preceding claims, wherein the active metal layer (31) has a first thickness (D1) and the wetting metal layer (32) has a second thickness (D2), wherein the first thickness (D1) and/or the second thickness (D2) has a value between 0 and 5000 nm, more preferably between 50 and 2500 nm and most preferably between 100 nm and 1000 nm.

9. Method for the production of a metal-ceramic substrate according to one of the preceding claims, comprising
- forming an interface metallization (15) on the at least one insulating layer, wherein the interface metallization (15) comprises an active metal layer (31) and a wetting metal layer (32),
- wherein the active metal layer (31) and/or the wetting metal layer (32) is subjected to an energy input (40) in order to form the interface metallization (15).

## Revendications

1. Procédé de fabrication d'un substrat métal-céramique (1), dans lequel au moins une couche céramique (10) et au moins une couche métallique (20) sont superposées le long d'une direction d'empilement (S), et ladite au moins une couche métallique (20) est structurée pour former des pistes conductrices ou des points de liaison pour des composants électriques, consistant à
- fournir ladite au moins une couche céramique (10) ;
- former une métallisation d'interface (15) sur ladite au moins une couche céramique (10), la métallisation d'interface (15) comprenant une couche de métal actif (31) et une couche de métal mouillant (32), et
- lierladite au moins une couche métallique (20) à la métallisation d'interface (15), en particulier par un procédé de liaison de métal directe, comme par exemple un procédé DCB ou DAB, ou par un procédé de brasage actif, pour former le substrat métal-céramique (1),
la couche de métal actif (31) et/ou la couche de métal mouillant (32) étant exposée à un apport d'énergie (40) pour former la métallisation d'interface (15), **caractérisé en ce que** l'on utilise une lumière ou un chauffage inductif comme apport d'énergie (40).

2. Procédé selon la revendication 1, consistant en outre à
- prévoir un agencement au moins localement primaire de la couche de métal actif (31) sur ladite au moins une couche céramique (10), et en particulier
- prévoir un agencement au moins localement secondaire de la couche de métal mouillant (32) sur la couche de métal actif (31), de préférence, la couche de métal actif (31) étant exposée à un apport d'énergie supplémentaire (40') entre l'agencement primaire et l'agencement secondaire.

3. Procédé selon la revendication 2,
dans lequel l'agencement primaire et/ou l'agencement secondaire est réalisé par un procédé de dépôt, en particulier par un procédé de dépôt physique en phase vapeur.

4. Procédé selon l'une des revendications précédentes,
dans lequel un matériau de brasage (35) est agencé entre ladite au moins une couche métallique (20) et la métallisation d'interface (15), la couche de métal actif (31) et/ou la couche de métal mouillant (32) étant exposée à l'apport d'énergie (40) temporellement après l'agencement du matériau de brasage (35) entre ladite au moins une couche métallique (20) et la métallisation d'interface (15).

5. Procédé selon l'une des revendications précédentes,
dans lequel on utilise de la lumière comme apport d'énergie supplémentaire (40').

6. Procédé selon la revendication 5,
dans lequel on utilise un flash lumineux, l'apport d'énergie (40') du flash lumineux sur la couche de métal actif (31) et/ou la couche de métal mouillant (32) étant de préférence d'au moins 5 kW, de préférence d'au moins 8 kW et de manière particulièrement préférée entre 10 et 15 kW.

7. Procédé selon l'une des revendications précédentes,
dans lequel on utilise un frittage comme apport d'énergie supplémentaire (40').

8. Procédé selon l'une des revendications précédentes,
dans lequel la couche de métal actif (31) présente une première épaisseur (D1) et la couche de métal mouillant (32) présente une deuxième épaisseur (D2), la première épaisseur (D1) et/ou la deuxième épaisseur (D2) prenant une valeur comprise entre 0 et 5000 nm, de préférence entre 50 et 2500 nm et de manière particulièrement préférée entre 100 nm et 1000 nm.

9. Procédé de fabrication d'un substrat métal-céramique selon l'une des revendications précédentes, consistant à
- former une métallisation d'interface (15) sur au moins une couche isolante, ladite métallisation d'interface (15) comprenant une couche de métal actif (31) et une couche de métal mouillant (32),
la couche de métal actif (31) et/ou la couche de métal mouillant (32) étant exposée à un apport d'énergie (40) pour former la métallisation d'interface (15).
